(19) Europäisches Patentamt
European Patent Office
Office européen des brevets

(11) Veröffentlichungsnummer: **0 219 789 B1**

(12) **EUROPÄISCHE PATENTSCHRIFT**

(45) Veröffentlichungstag der Patentschrift: **26.02.92**

(51) Int. Cl.⁵: **G03F 7/26**

(21) Anmeldenummer: **86114147.1**

(22) Anmeldetag: **13.10.86**

# (54) Lösemittel zum Entfernen von Photoresists.

(30) Priorität: **22.10.85 DE 3537441**

(43) Veröffentlichungstag der Anmeldung:
**29.04.87 Patentblatt 87/18**

(45) Bekanntmachung des Hinweises auf die Patenterteilung:
**26.02.92 Patentblatt 92/09**

(84) Benannte Vertragsstaaten:
**BE CH DE FR GB IT LI NL SE**

(56) Entgegenhaltungen:
**US-A- 3 796 602**
**US-A- 4 077 896**

**PATENT ABSTRACTS OF JAPAN, Band 7, Nr. 6 (P-167)[1151], 11. Januar 1983; & JP-A-57 165 834 (HITACHI KASEI KOGYO K.K.) 13-10-1982**

**PATENT ABSTRACTS OF JAPAN, Band 7, Nr. 54 (P-180)[1199], 4. März 1983; & JP-A-57 202 540 (MITSUWAKA JIYUNYAKU KENKYUSHO K.K.) 11-12-1982**

(73) Patentinhaber: **HOECHST AKTIENGESELLSCHAFT**
**Postfach 80 03 20**
**W-6230 Frankfurt am Main 80(DE)**

(72) Erfinder: **Merrem, Hans-Joachim, Dr.**
**Donnersbergstrasse 6**
**W-6104 Seeheim-Jugenheim(DE)**
Erfinder: **Schmitt, Axel, Dr.**
**Lärchenweg 5**
**W-6229 Walluf 2(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Rank Xerox (UK) Business Services

## Beschreibung

Die vorliegende Erfindung beschreibt neue Lösemittelsysteme zum Entfernen von Photoresists auf der Basis von wasserlöslichen Aminoderivaten und Propylenglykolverbindungen.

Photoresists werden bei der Herstellung von integrierten Bauelementen, Leiterplatten und in verwandten Technologien als Masken für Strukturierungsverfahren, wie z.B. Atz- oder Implantationsprozesse eingesetzt. Sie werden anschließend in der Regel wieder entfernt; sehr häufig werden dazu Lösemittelgemische verwendet, die- je nach Wirkungsweise - in der angelsächsischen Literatur als Stripper oder Remover bezeichnet werden.

Derartige Systeme sind z.B. von W. S. De Forest (Photoresist: Materials and Processes, Seiten 203 ff., Mc. Graw-Hill Book Co., New York, 1975) beschrieben worden. Sie enthalten beispielsweise chlorierte Kohlenwasserstoffe wie Methylenchlorid; polare Lösemittel wie Dimethylformamid, N-Methyl-2-pyrrolidon, Monoethanolamin; Glykolether wie Ethylenglykolmonoethylether, Ethylenglykolmonobutylether oder deren Acetate; starke Basen wie Tetramethylammoniumhydroxid oder starke Säuren wie Schwefelsäure-$H_2O_2$-Mischungen.

In der US-A 3,673,099 wird ein Gemisch aus N-Methyl-2-pyrrolidon und einer starken Base wie Tetramethylammoniumhydroxid, beschrieben. Derartige Mischungen sind dafür bekannt, daß sie empfindliche Substrate, wie z.B. Aluminiumschichten, angreifen, wenn Wasser zugesetzt wird. Es ist aber wünschenswert, ein Produkt zum Ablösen von Photoresistschichten, sowohl von empfindlichen als auch von weniger empfindlichen Substratschichten, einsetzen zu können, da häufig beide Schichttypen gleichzeitig vorkommen.

Es ist ferner bekannt, daß sich Tetramethylammoniumhydroxid bei Erwärmung leicht zersetzt und dadurch die Standzeit des Entfernungsmittels bei höheren Temperaturen sehr kurz ist.

In der US-A 3,796,602 wird ein System beschrieben, das ein mit Wasser partiell mischbares organisches Lösemittel enthält. Die genannten Verbindungen, wie Ethylenglykolmonobutylether und Monoaminoethanol, sind jedoch als toxikologisch bedenklich anzusehen. Darüber hinaus sind diese Verbindungen aufgrund ihrer niedrigen Siedepunkte leicht verdampfbar und damit für den Einsatz bei hohen Temperaturen ungeeignet.

In der EP-A 0 075 329 wird ein Gemisch aus einem 2-Pyrrolidonderivat und einem Diethylenglykolmonoalkylether beschrieben. Die Leistungsfähigkeit derartiger Gemische ist jedoch gering. So wird in den aufgeführten Beispielen eine Badtemperatur von 75 °C für erforderlich gehalten, um Photoresist zu entfernen, der bei 150 °C nachgetrocknet wurde.

In der EP-A 0 145 973 wird ein System aus einem Piperazinderivat und einem N-Alkyl-2-pyrrolidon aufgeführt. Das bevorzugt genannte N-Aminoethylpiperazin ist als giftig klassifiziert, während das N-Hydroxyethylpiperazin nur eine geringe Wirksamkeit besitzt.

Es stellte sich somit die Aufgabe, ein Entfernungsmittel für Photoresists zu finden, das sowohl bei hohen als auch bei niedrigen Temperaturen einsetzbar, toxikologisch unbedenklich und mit Wasser abspülbar ist und keine oder nur äußerst geringe Aggressivität gegenüber empfindlichen Substraten zeigt.

Die beschriebenen Lösemittelsysteme sind sowohl zum Entfernen von positiv arbeitenden Resists als auch von photopolymerisierbaren Resists geeignet. Bevorzugt werden Resists abgelöst, die mit wäßrigalkalischen Lösungen entwickelt werden können.

Gelöst wird die vorstehend genannte Aufgabe durch ein Mittel zum Entfernen von Photoresists bestehend aus

a) 10 bis 90 Gew.-% wenigstens eines wasserlöslichen Amins der allgemeinen Formel

$$H_2N-[(\underset{R^2}{\overset{R^1}{C}})_n-(\underset{R^4}{\overset{R^3}{C}})_m-O,NH]_oH$$

wobei

| | |
|---|---|
| $R^1, R^2, R^3, R^4$ = | H, Alkyl |
| n, m = | 0 bis 2, mit der Maßgabe daß $n + m \geq 2$ |
| o = | 1 bis 3 |

bedeuten und

b) 90 bis 10 Gew.-% wenigstens eines wasserlöslichen Propylenglykolderivats der allgemeinen Formel

$$R^3 - O - [CH_2 - \underset{\displaystyle CH_3}{\underset{|}{CH}} - O]_p - R^4$$

$$\text{wobei} \quad R^3, R^4 = H, \text{Alkyl}, \underset{\displaystyle O}{\overset{}{\underset{\|}{C}}}\text{-Alkyl}$$

$$p = 1 \text{ bis } 3$$

bedeuten.

Es wurde festgestellt, daß die erfindungsgemäßen Gemische aus wasserlöslichen Propylenglykolethern und Aminoverbindungen als Entfernungsmittel für Photoresists verwendet werden können, die die obengenannten Nachteile des Standes der Technik nicht aufweisen. Bevorzugt lassen sich Mischungen einsetzen, die aufgrund des hohen Siedepunktes der Einzelkomponenten von ≧ 180 °C nur einen geringen Masseverlust zeigen, wenn das Mittel über längere Zeit bei hohen Temperaturen eingesetzt wird. Eine besonders bevorzugte Mischung besteht aus N-(2-Aminoethyl)-ethanolamin und Tripropylenglykolmethylether.

Es war nicht vorhersehbar, daß das erfindungsgemäße Mittel, das hochsiedende Propylenglykoletherderivate, wie z.B. Tripropylenglykolmethylether, enthält, auch bei Raumtemperatur noch gute Eigenschaften zeigt. Für den vorgesehenen Einsatzzweck ist die hier beschriebene Erfindung damit insoweit vorteilhaft, als ein derartiges Mittel sowohl bei Raumtemperatur als auch - aufgrund des günstigen Verdunstungsverhaltens - bei hohen Badtemperaturen effektiv eingesetzt werden kann.

Zusätzlich wurde festgestellt, daß die besonders bevorzugte Formulierung aus Tripropylenglykolmethylether und N-(2-Aminoethyl)-ethanolamin einen synergetischen Effekt aufweist.

Da in der Praxis häufig auch Photoresistschichten entfernt werden müssen, die keinen hohen Temperaturen ausgesetzt waren, können auch Mittel als bevorzugt angesehen werden, deren Einzelkomponenten Siedepunkte von 160 °C oder mehr aufweisen. Besonders bevorzugt sind hierbei Mischungen aus Dipropylenglykolmethylether und Isopropanolamin. Auch für derartige Systeme gelten die oben aufgeführten Vorteile, d.h., sie sind sowohl bei Raumtemperatur als auch bei höheren Temperaturen einsetzbar - wenn auch aufgrund der höheren Verdunstungsraten der Einsatz dieser Mittel bei niedrigeren Badtemperaturen bevorzugt ist -, und sie weisen einen synergetischen Effekt auf.

Obwohl die Propylenglykolether, wie die hier bevorzugten Dipropylenglykolmethylether oder Tripropylenglykolmethylether als deutlich hydrophober im Vergleich zu den analogen Ethylenglykoletherprodukten anzusehen sind und daher gute Löseeigenschaften für organische Polymere aufweisen, lassen sich die hier genannten Mittel ohne Bildung von Rückständen leicht mit Wasser abspülen.

Trotz ihrer hohen Wirksamkeit verhalten sich die genannten Mischungen gegenüber empfindlichen Substraten, wie z.B. Aluminiumschichten, nicht aggressiv.

Bevorzugt werden Mischungen eingesetzt, die 20 bis 70 Gew.-% des Amins und 30 bis 80 Gew.-% des Propylenglykolderivats enthalten. Besonders bevorzugt werden diese Verhältnisse beim Einsatz von Isopropanolamin und/oder N-(2-Aminoethyl)-ethanolamin und Di- oder Tripropylenglykolmethylether eingehalten.

Für alle genannten Systeme kann neben sehr geringer Toxität als weiterer Vorteil die Tatsache festgestellt werden, daß die verwendeten Verbindungen nur einen geringen Eigengeruch aufweisen und damit beispielsweise auch in offenen Bädern eingesetzt werden können.

Es versteht sich im Rahmen der Erfindung, daß auch Mischungen eines oder mehrerer Amine(s) mit einem oder mehreren Propylenglykolderivat(en) eingesetzt werden können.

Obwohl es dem Stand der Technik entspricht, Photoresists im Tauchverfahren zu entfernen, wobei üblicherweise die mit Photoresist beschichteten Substrate in einem Bad bewegt werden bzw. das Bad z.B. durch Umpumpen in Bewegung gehalten wird, lassen sich die erfindungsgemäßen Mittel auch in anderen Verfahren, wie z.B. Sprüh- oder Puddle-Verfahren, einsetzen.

Die Erfindung wird anhand folgender Beispiele näher erläutert, ohne jedoch auf die gezeigten Ausführungsformen beschränkt zu sein.

Beispiele 1 bis 5

Die Wirksamkeit des Entfernungsmittels wurde an Photoresistschichten geprüft, wie sie bei der Herstellung von integrierten Schaltkreisen üblicherweise Verwendung finden. Dazu wurde ein handelsüblicher Photoresist auf der Basis von Diazochinon/Novolak (AZ 1350 J) mit 4.000 U/min auf Siliciumwafer aufgeschleudert und bei 90 °C für 30 min getrocknet. Die Schichtdicke wurde mit 1,8 µm bestimmt. Anschließend wurden die Substrate bei 200 °C für 30 min erhitzt.

Die Ablöseversuche wurden in einem gerührten, temperierten Bad bei 80 °C durchgeführt. Nach 10 min Badzeit wurden die Wafer mit entionisiertem Wasser gespült und die verbleibende Resistschichtdicke gemessen. Die Ergebnisse, die in Tabelle 1 wiedergegeben sind, zeigen deutlich die überlegene Wirksamkeit von erfindungsgemäß eingesetztem N-(2-Aminoethyl)-ethanolamin (AEEA) und Isopropanolamin (IPA). Verhältnismäßig gute Entfernungseigenschaften zeigt zwar auch Triethylentetramin, das jedoch aufgrund seiner toxikologischen Eigenschaft als nicht bevorzugt angesehen werden kann.

Die in dem Vergleich aufgeführten Amine wurden in jeweils äquimolaren Mengen eingesetzt.

Beispiele 6 bis 12

In den folgenden Beispielen wurde ebenfalls die Wirksamkeit verschiedener Aminoverbindungen geprüft. Auch in diesem Fall wurde die Zusammensetzung so gewählt, daß jeweils gleiche molare Mengen eingesetzt wurden.

Die Versuchsbedingungen waren die gleichen wie bei den Beispielen 1 bis 5, jedoch waren die Substrate auf 160 °C für 30 min erhitzt worden; die Badtemperatur betrug 22 °C. Es wurde wiederum die Resistschichtdicke gemessen; die Lösezeit war auf 10 min festgelegt worden.

Die in Tabelle 2 wiedergegebenen Ergebnisse zeigen, daß N-(2-Aminoethyl)-ethanolamin und Triethylentetramin auch bei 22 °C überlegene Löseeigenschaften zeigen. Während die Kombination von Isopropanolamin mit Tripropylenglykolmethylether (TPM) in diesem Fall als weniger bevorzugt anzusehen ist, zeigt das Gemisch aus Isopropanolamin und Dipropylenglykolmethylether bei Raumtemperatur gute Eigenschaften.

Beispiele 13 bis 18

Analog zu den Beispielen 1 bis 5 wurden verschiedene Gemische aus N-(2-Aminoethyl)-ethanolamin und Tripropylenglykolmethylether geprüft. Die Substrate waren bei 200 °C für 30 min erhitzt worden; die Badtemperatur betrug 80 °C.

Die Ergebnisse für eine Badzeit von 4 min sind in Tabelle 3 wiedergegeben. Unter diesen Bedingungen werden die Photoresistschichten noch nicht vollständig entfernt, andererseits läßt sich der synergetische Effekt zwischen N-(2-Aminoethyl)-ethanolamin und Tripropylenglykolmethylether durch die Messung der Resistschichtdicken von unvollständig gelöstem Photoresist eindrucksvoll demonstrieren. Als optimale Zusammensetzung wurde ein Gemisch aus 51 Gew.-% N-(2-Aminoethyl)-ethanolamin und 49 Gew.-% Tripropylenglykolmethylether ermittelt.

Beispiele 19 bis 21

Analog zu den Beispielen 13 bis 18 wurde der synergetische Effekt zwischen Isopropanolamin und Dipropylenglykolmethylether (DPM) bestimmt. Auch in diesem Fall war die Badzeit so gewählt worden, daß noch meßbare Resistschichten zurückblieben.

Das in Tabelle 4 wiedergegebene Ergebnis zeigt, daß eine optimale Wirksamkeit bei einem Mischungsverhältnis aus 22,5 Gew.-% Isopropanolamin und 77,5 Gew.-% Dipropylenglykolmethylether beobachtet wird.

Beispiele 22 und 23

Das Verhalten der Mittel gegen Aluminiumschichten wurde dadurch geprüft, daß die Mittel gemäß den Beispielen 13 und 19 auf 80 °C erwärmt wurden und 30 min lang auf mit Aluminium beschichtete Wafer einwirken konnten. Es war kein Angriff auf die Aluminiumschicht zu beobachten.

Tabelle 1

| Beispiel Nr. | Zusammensetzung | Resistschichtdicke |
|---|---|---|
| 1 | 64,4 Gew.-% Di-(n-propylen)-triamin<br>35,6 Gew.-% Tripropylenglykolmethylether (TPM) | 0,380 µm |
| 2 | 50,7 Gew.-% Diethylentriamin<br>49,3 Gew.-% TPM | 0,249 µm |
| 3 | 71,8 Gew.-% Triethylentetramin<br>28,2 Gew.-% TPM | 0 µm |
| 4 | 36,9 Gew.-% Isopropanolamin (IPA)<br>63,1 Gew.-% TPM | 0 µm |
| 5 | 51,0 Gew.-% N(2-Aminoethyl)ethanolamin (AEEA)<br>49,0 Gew.-% TPM | 0 µm |

Tabelle 2

| Beispiel Nr. | Zusammensetzung | Resistschichtdicke |
|---|---|---|
| 6* | 63,9 Gew.-% Hydroxyethylpiperazin<br>36,1 Gew.-% TPM | 1,517 µm |
| 7 | 51,6 Gew.-% Aminoethoxyethanol<br>48,4 Gew.-% TPM | 0,396 µm |
| 8 | 50,7 Gew.-% Diethylentriamin<br>49,3 Gew.-% TPM | 0,369 µm |
| 9 | 36,9 Gew.-% IPA<br>63,1 Gew.-% TPM | 0,293 µm |
| 10 | 71,8 Gew.-% Triethylentetramin<br>28,2 Gew.-% TPM | 0 µm |
| 11 | 51,0 Gew.-% AEEA<br>49,0 Gew.-% TPM | 0 µm |
| 12 | 36,9 Gew.-% IPA<br>63,1 Gew.-% Dipropylenglykolmethylether (DPM) | 0 µm |

* Vergleichsbeispiel

Tabelle 3

| Beispiel Nr. | Zusammensetzung | Resistschichtdicke |
|---|---|---|
| 13 | 75 Gew.-% N-(2-Aminoethyl)-ethanol-amin (AEEA)<br>25 Gew.-% Tripropylenglykolmethyl-ether (TPM) | 0,652 µm |
| 14 | 51 Gew.-% AEEA<br>49 Gew.-% TPM | 0,387 µm |
| 15 | 35 Gew.-% AEEA<br>65 Gew.-% TPM | 0,758 µm |
| 16 | 25 Gew.-% AEEA<br>75 Gew.-% TPM | 0,860 µm |
| 17 | 15 Gew.-% AEEA<br>85 Gew.-% TPM | 0,896 µm |
| 18 | 10 Gew.-% AEEA<br>90 Gew.-% TPM | 1,174 µm |

Tabelle 4

| Beispiel Nr. | Zusammensetzung | Resistschichtdicke |
|---|---|---|
| 19 | 10,0 Gew.-% IPA<br>90,0 Gew.-% DPM | 1,22 µm |
| 20 | 22,5 Gew.-% IPA<br>77,5 Gew.-% DPM | 0,50 µm |
| 21 | 36,9 Gew.-% IPA<br>63,1 Gew.-% DPM | 0,83 µm |

Beispiele 24 bis 27

Die Wirksamkeit der Entfernungsmittel wurde an photopolymerisierbaren, wäßrig-alkalisch entwickelbaren Photoresists geprüft, wie sie üblicherweise in der Leiterplattenherstellung eingesetzt werden. Dazu wurde ein handelsüblicher Trockenresist (Ozatec(R) T 138, Hersteller: Hoechst AG) auf ein kupferkaschiertes Laminat bei 115 °C laminiert, mit einem 5 kw MH-Brenner im Abstand von 60 cm für 8 sec belichtet und in einer 1%igen wäßrigen $Na_2CO_3$-Lösung in 70 sec bei 30 °C entwickelt.

Die Ablöseversuche wurden in einem gerührten, temperierten Bad bei + 50 °C durchgeführt. Nach 10 min Badzeit waren die in Tabelle 5 aufgeführten Ergebnisse erzielt worden. Es sind sowohl die unverdünnten Entfernungsmittel als auch mit Wasser verdünnte Formulierungen zum Ablösen der Resists geeignet.

Tabelle 5

| Beispiel Nr. | Zusammensetzung | Resist abgelöst |
|---|---|---|
| 24 | 51 % AEEA<br>49 % TPM | ja |
| 25 | 12,75 % AEEA<br>12,25 % TPM<br>75 % Wasser | ja |
| 26 | 22,5 % IPA<br>77,5 % DPM | ja |
| 27 | 5,63 % IPA<br>19,37 % DPM<br>75 % Wasser | ja |

**Patentansprüche**

**1.** Mittel zum Entfernen von Photoresists bestehend aus

a) 10 bis 90 Gew.-% wenigstens eines wasserlöslichen Amins der allgemeinen Formel

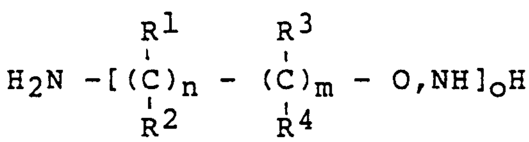

wobei
$R^1$, $R^2$, $R^3$, $R^4$ = H, Alkyl
n, m = 0 bis 2, mit der Maßgabe, daß n + m ≧ 2
o = 1 bis 3
bedeuten und
b) 90 bis 10 Gew.-% wenigstens eines wasserlöslichen Propylenglykolderivats der allgemeinen Formel

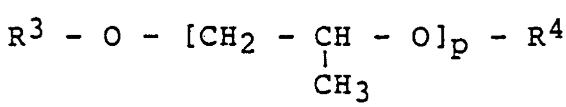

wobei $R^3$, $R^4$ = H, Alkyl, $\underset{O}{\underset{\|}{C}}$-Alkyl

p = 1 bis 3

bedeuten.

**2.** Mittel nach Anspruch 1, bestehend aus Isopropanolamin oder N-(2-Aminoethyl)-ethanolamin sowie Di- oder Tripropylenglykolmethylether.

**3.** Mittel nach Anspruch 1, dadurch gekennzeichnet, daß sie 20 bis 70 Gew.-% Amin und 30 bis 80 Gew.-% Propylenglykolderivat enthalten.

**4.** Mittel nach einem der Ansprüche 1 bis 3, dadurch gekennzeichnet, daß die Siedepunkte der Komponenten ≧ 160 °C betragen.

**5.** Mittel nach einem der Ansprüche 1 bis 3, dadurch gekennzeichnet, daß die Siedepunkte der Komponenten ≧ 180 °C betragen.

**Claims**

**1.** Agents for photoresist removal, which are comprised of

a) 10 to 90 % by weight of at least one water-soluble amine of the general formula

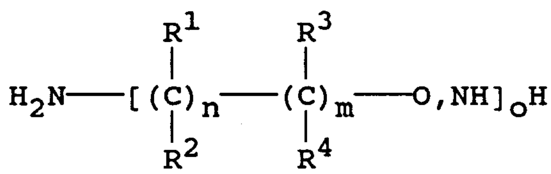

in which

| | |
|---|---|
| $R^1$, $R^2$, $R^3$, $R^4$ | denote H or alkyl, |
| n,m | denote 0 to 2, with the proviso that n + m ≧ 2, and |
| o | denotes 1 to 3; and of |

b) 90 to 10 % by weight of at least one water-soluble propylene glycol derivative of the general formula

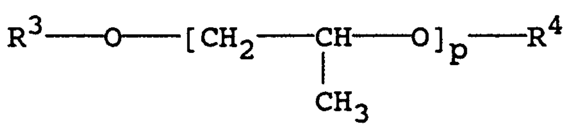

in which

| | |
|---|---|
| $R^3$, $R^4$ | denote H, alkyl or 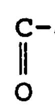-alkyl, and |
| p | denotes 1 to 3. |

**2.** Agents as claimed in claim 1, comprised of isopropanol amine or N-(2-aminoethyl)-ethanol amine and di- or tripropylene glycol methyl ether.

**3.** Agents as claimed in claim 1, wherein 20 to 70 % by weight of amine and 30 to 80 % by weight of propylene glycol derivative are contained.

**4.** Agents as claimed in any of claims 1 to 3, wherein the boiling points of the individual components are 160 °C or higher.

**5.** Agents as claimed in any of claims 1 to 3, wherein the boiling points of the individual components are 180 °C or higher.

**Revendications**

**1.** Agents pour l'élimination de photoresists, constitués de
a) de 10 à 90 % en poids d'au moins une amine soluble dans l'eau, de formule générale

$$H_2N-[(\underset{R^2}{\overset{R^1}{C}})_n-(\underset{R^4}{\overset{R^3}{C}})_m-O,NH]_oH$$

dans laquelle

| | |
|---|---|
| $R^1$, $R^2$, $R^3$, $R^4$ | représentent un atome d'hydrogène ou un groupe alkyle, |
| n, m | vont de 0 à 2, étant entendu que $n + m \geqq 2$, |
| o | va de 1 à 3, et |

b) de 90 à 10 % en poids d'au moins un dérivé de propylèneglycol soluble dans l'eau, de formule générale

$$R^3-O-[CH_2-\underset{CH_3}{CH}-O]_p-R^4$$

dans laquelle

$R^3$, $R^4$ représentent H ou un groupe alkyle ou $\underset{O}{\overset{}{\underset{\|}{C}}}$-alkyle

p va de 1 à 3.

2. Agents selon la revendication 1, constitués d'isopropanolamine ou de N-(2-aminoéthyl)-éthanolamine ainsi que d'éther méthylique de di- ou tripropylèneglycol.

3. Agents selon la revendication 1, caractérisés en ce qu'ils contiennent de 20 à 70 % en poids d'amine et de 30 à 80 % en poids de dérivé de propylèneglycol.

4. Agents selon l'une des revendications 1 à 3, caractérisés en ce que les points d'ébullition des composants sont ≧ 160 °C.

5. Agents selon l'une des revendications 1 à 3, caractérisés en ce que les points d'ébullition des composants sont ≧ 180 °C.